# EUROPEAN PATENT APPLICATION

(11) **EP 3 503 169 A1**
(43) Date of publication of application: **26.06.2019**
(21) Application number: 18213523.6
(22) Date of filing: 18.12.2018
(51) Int. Cl.: H01L 21/3213, H01L 21/768

(54) **METHODS OF ETCHING A TUNGSTEN LAYER**

(30) Priority: 22.12.2017 US 201715853165
(71) Applicant: Applied Materials, Inc., Santa Clara, CA 95054 (US)
(72) Inventor: Mullick, Amrita B., Santa Clara, CA California 95051 (US); Emesh, Ismail T., Sunnyvale, CA California 94087 (US); Mitra, Uday, Cupertino, CA California 95014 (US); Shaviv, Roey, Palo Alto, CA California 94306 (US); Freed, Regina, Los Altos, CA California 94024 (US)
(74) Representative: Zimmermann & Partner Patentanwälte mbB

(57) **Abstract**

Methods of etching tungsten are disclosed including: leveling a first top surface of a tungsten layer within a feature and atop a top surface of a substrate; and etching the tungsten layer with a peroxide such as hydrogen peroxide and one of a strong acid or a strong base to remove a first portion of the tungsten layer from atop the substrate to form a second top surface of a tungsten layer at a level below the top surface of the substrate. The methods are suitable for forming substantially level or flat top surfaces of a tungsten layer at a level below the top surface of the substrate or within one or more features such as vias or trenches.

## Description

### FIELD

Embodiments of the present disclosure generally relate to device manufacture and, in particular, etching tungsten in a feature such as a trench or via.

### BACKGROUND

Tungsten is a material solution for fabrication of devices such as integrated circuits, contact, and BEOL (back end of the line) interconnect fill applications in the 10/7 nm nodes and beyond. Tungsten (W) is often disposed within or atop dielectric layers such as SiN or SiO dielectric layers, however, the inventors have observed difficulty obtaining a desired smooth surface of locally planarized tungsten within features including a dielectric layer such as a trench or via. Further, the inventors have observed that dry etch of tungsten is problematic in that dry etch is often selective towards the dielectric layer leading to faster etching of the dielectric layer over tungsten resulting in unacceptable trenches having uneven tungsten surfaces disposed therein. Moreover, the inventors have observed that uneven surfacing, such as dishing of the top tungsten layer surface within a feature, limits additional processing and downward scaling of tungsten features (e.g., interconnects).

Accordingly, the inventors have provided an improved method for etching tungsten disposed within or atop a substrate such as a dielectric layer.

### SUMMARY

Methods for etching tungsten are provided herein. In some embodiments, a method of etching tungsten, includes: leveling a first top surface of a tungsten layer within a feature and atop a top surface of a substrate; and etching the tungsten layer with a hydrogen peroxide and one of a strong acid or a strong base to remove a first portion of the tungsten layer from atop the substrate to form a second top surface of a tungsten layer at a level below the top surface of the substrate.

In some embodiments, a method of etching tungsten, includes: planarizing a top surface of a tungsten layer having a portion disposed within a feature and a portion protruding from the feature to form a first level top surface on the portion protruding from the feature, wherein the portion disposed within the feature is disposed upon a dielectric layer; and contacting the first level top surface with an etch solution including an oxidizing agent and one of a strong acid or strong base for a time sufficient to etch the portion protruding from the feature to form a second top surface within the feature, wherein the second top surface is substantially level.

In some embodiments, a method of etching tungsten, includes: contacting a substantially level first top surface of a tungsten layer having a portion disposed within a feature with hydrogen peroxide and one of a strong acid or a strong base for a time sufficient to etch the tungsten layer to form a second top surface within the feature, wherein the second top surface is substantially level.

In some embodiments, a method of etching tungsten, includes: contacting a substantially level first top surface of a tungsten layer having a portion disposed within a feature with hydrogen peroxide for a time sufficient to etch the tungsten layer to form a second top surface within the feature, wherein the second top surface is substantially level.

In some embodiments, a method of etching a tungsten layer disposed on a substrate, including: contacting a substantially level first top surface of a tungsten layer with hydrogen peroxide, and optionally one of a strong acid or a strong base for a time sufficient to etch the substantially level first top surface of the tungsten layer to form a substantially level second top surface within a feature disposed in the substrate.

In some embodiments, a method of etching tungsten, including: planarizing a top surface of a tungsten layer disposed atop a substrate and above a feature formed in a dielectric layer of the substrate to form a first level top surface of the tungsten layer above the feature; and contacting the first level top surface of the tungsten layer with an etch solution comprising an oxidizing agent and one of a strong acid or strong base for a time sufficient to etch the first level top surface of the tungsten layer to form a second level top surface of the tungsten layer within the feature.

Other and further embodiments of the present disclosure are described below.

### BRIEF DESCRIPTION OF THE DRAWINGS

Embodiments of the present disclosure, briefly summarized above and discussed in greater detail below, can be understood by reference to the illustrative embodiments of the disclosure depicted in the appended drawings. However, the appended drawings illustrate only typical embodiments of the disclosure and are therefore not to be considered limiting of scope, for the disclosure may admit to other equally effective embodiments.
Figure 1 depicts a flow diagram of a method for etching tungsten in a feature of a semiconductor device in accordance with embodiments of the present disclosure.
Figures 2A-2D respectively depict stages of fabrication of etching tungsten in features of a semiconductor device in accordance with embodiments such as figure 1 of the present disclosure.

While the foregoing is directed to embodiments of the present disclosure, other and further embodiments of the disclosure may be devised without departing from the basic scope thereof.

### DETAILED DESCRIPTION

The inventors have observed that tungsten deposited within a feature may be advantageously formed with level, smooth layers within a feature via a metal fill and/or process including a wet etch in accordance with the present disclosure. Reducing or eliminating dishing and non-level layering within a feature leads to device yield increase, reduced manufacturing costs, and an increase in uniformity across a plurality of features during the formation of a semiconductor device. Increased uniformity enhances application of additional process layers as manufacturing continues. Thus, embodiments of the present disclosure may advantageously be used during different CVD and ALD processes or devices that may be subjected to further processing. In some embodiments, methods of the present disclosure advantageously provide tungsten films or layers having significantly improved level layer formation, such as a flat top surface within a feature, and production level throughput.

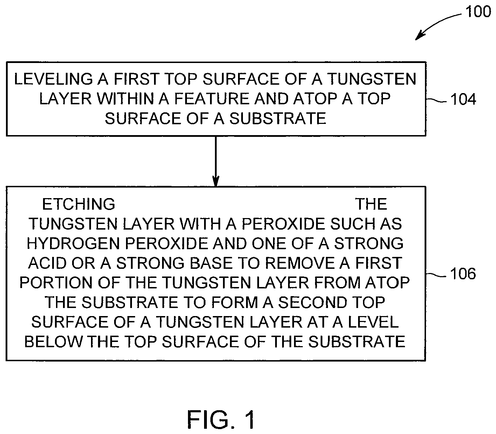

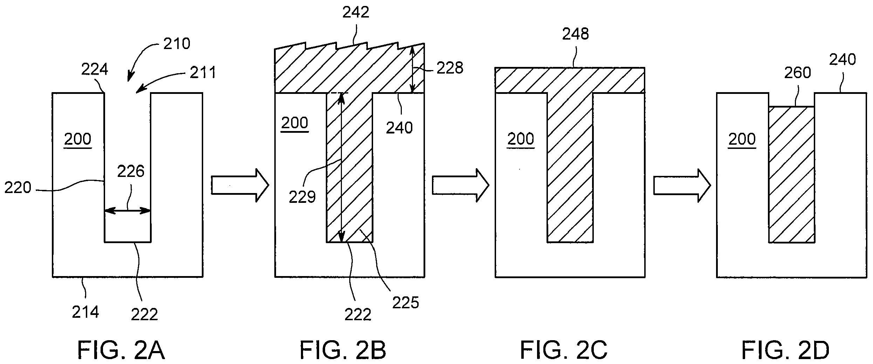

Figure 1 is a flow diagram of a method 100 processing a substrate in accordance with some embodiments of the present disclosure. The method 100 is described below with respect to the stages of processing a substrate as depicted in Figures 2A-2D.

The method 100 is typically performed on a substrate 200 provided to a processing volume of a process chamber. In some embodiments, as shown in Figure 2A, the substrate 200 includes one or more features such as trench 210, (one shown in Figures 2A-D) to be filled in with a tungsten layer 225, the trench 210 extending towards a base 214 of the substrate 200. Although the following description is made with respect to one feature, the substrate 200 may include any number of features (such as a plurality of trenches 210, vias, self-aligning vias, self-aligned contact features, duel damascene structures, and the like) as described below or may be suitable for use in a number of process applications such as dual-damascene fabrication processes, self-aligned contact feature processing, and the like. Non-limiting examples of features suitable for etching in accordance with the present disclosure include trenches such as trench 210, vias, and duel-damascene type features, and features disclosed in U.S. Patent No. 6,403,491 to Liu et al.*,* entitled *Etch Method Using a Dielectric Etch Chamber With Expanded Process Window.*

Accordingly, substrate 200 may be any suitable substrate having one or more features such as via, self-aligning via, duel-damascene, or trench such as trench 210 formed in the substrate 200. In embodiments, substrate 200 may include one or more of silicon (Si), silicon oxide, such as silicon monoxide (SiO) or silicon dioxide (SiO₂), silicon nitride (such as SiN), or the like. In non-limiting embodiments, the substrate 200 may be a trench 210 formed in a dielectric layer, thus the dielectric layer may be substrate 200 or made of the same materials as described above such as SiN, SiO, and the like. In addition, the substrate 200 may include additional layers of materials or may have one or more completed or partially completed structures or devices formed in, on or under the substrate 200 (not shown). In embodiments, substrate 200 is a dielectric layer which may include additional substrate layering surrounding the dielectric layer or substrate 200 (not shown in FIGS 2A-2D). In embodiments, a low-k material may be suitable as a substrate or layer thereof (e.g., a material having a dielectric constant less than silicon oxide, or less than about 3.9), or the like. In embodiments, the substrate or one or more layers thereof may include, for example, a doped or undoped silicon substrate, a III-V compound substrate, a silicon germanium (SiGe) substrate, an epi-substrate, a silicon-on-insulator (SOI) substrate, a display substrate such as a liquid crystal display (LCD), a plasma display, an electro luminescence (EL) lamp display, a light emitting diode (LED) substrate, a solar cell array, solar panel, or the like. In some embodiments, the substrate 200 include a semiconductor wafer.

In embodiments, the substrate 200 may not be limited to any particular size or shape. The substrate may be a round wafer having a 200 mm diameter, a 300 mm diameter or other diameters, such as 450 mm, among others. The substrate 200 can also be any polygonal, square, rectangular, curved or otherwise non-circular workpiece, such as a polygonal glass substrate used in the fabrication of flat panel displays.

In some embodiments, features such as trench 210 may be formed by etching the substrate 200 using any suitable etch process. In embodiments, suitable feature(s) for use in accordance with the present disclosure include one or more high aspect ratio trench(es) having a width of less than 20 nanometers. In some embodiments, the trench 210 is defined by one or more sidewalls 220, a bottom surface 222 and upper corner(s) 224. In some embodiments, the trench 210 may have a high aspect ratio, e.g., an aspect ratio between about of about 5:1 and about 20:1. As used herein, the aspect ratio is the ratio of a depth of the feature to a width of the feature. In embodiments, the trench 210 has a width 226 less than or equal to 20 nanometers, less than or equal to 10 nanometers, or a width 226 between 5 to 10 nanometers.

In some embodiments, features such as one or more vias may be formed by etching the substrate 200 using any suitable etch process. In embodiments, suitable feature(s) for use in accordance with the present disclosure include one or more vias having a width of less than 20 nanometers. In some embodiments, via may include one or more sidewalls with a space between the one or more sidewalls. In embodiments, via may include self-aligning structures such as features described in U.S. Patent No. 9,343,272 to Pandit, et al.*,* and entitled *Self-aligned process.*

In some embodiments the substrate 200 comprises or consists of a dielectric layer of material described above such as silicon oxide, silicon monoxide (SiO), silicon dioxide (SiO₂), silicon nitride (such as SiN), or the like and shaped having an opening 211, a surface opposite the opening such as bottom surface 222, and sidewalls 220 between the opening 211 and bottom surface 222, i.e., the surface opposite the opening 211.

An underlayer (not shown in Figure 2A-D) may optionally be deposited on substrate 200 and within the feature such as trench 210 in a process chamber configured to deposit a layer. The underlayer can be a layer conformably formed along at least a portion of the sidewalls 220 and/or bottom surface 222 of a feature such as trench 210 such that a substantial portion of the feature prior to the deposition of the layer remains unfilled after deposition of the layer. In some embodiments, the underlayer may be formed along the entirety of the sidewalls 220, such as two sidewalls, and bottom surface 222 of the trench 210. The underlayer may be a wetting layer provided to enhance the adherence of a metal layer disposed upon the underlayer. In embodiments, the underlayer may be a liner. In embodiments, the underlayer comprises titanium, titanium nitrate, tantalum nitrate and the like. In embodiments, the liner is etched at the same rate and same selectivity as tungsten layer as described below.

Referring to Figures 2B, a tungsten layer 225 is shown deposited atop the substrate 200 and within a feature such as trench 210. In embodiments, tungsten layer 225 includes tungsten or a tungsten alloy. In some embodiments, the tungsten layer 225 may also include, however, other metals, tungsten alloys, and dopants, such as nickel, tin, titanium, tantalum, molybdenum, platinum, iron, niobium, palladium, nickel cobalt alloys, doped cobalt, and combinations thereof. In embodiments, the tungsten and tungsten-containing material is substantially pure tungsten, or tungsten with no more than 1, 2, 3, 4, or 5% impurities. In embodiments, the tungsten layer 225 is a tungsten film or tungsten-containing film resulting from the CVD and ALD processing and may include a pure tungsten (W), tungsten nitride (WN), tungsten silicide (WₖSiₗ), or tungsten oxide (WₙOₘ) film, wherein k, I, m, and n are integers which inclusively range from 1 to 6. In embodiments, tungsten containing carbon species may be avoided, for example, tungsten carbide (WC), tungsten carbonitride (WCN) or the like may be excluded and not used to form tungsten layer 225.

In some embodiments, as shown in Figure 2B, the tungsten layer 225 is deposited atop a bottom surface 222 of the substrate 200 and within the trench 210 formed in the substrate 200. The tungsten layer 225 may be deposited using any suitable deposition process(es) or processing chamber. For example, one suitable non-limiting example of a processing chamber may include the OLYMPIA™ brand ALD system available from Applied Materials, Inc. of Santa Clara, California. Other suitable process chambers may similarly be used.

In some embodiments, the tungsten is pretreated by heating the tungsten to at least 450 degrees Celsius prior to depositing into the feature such as trench 210. In embodiments, the tungsten is heated to form tungsten with an increased grain size and increased hardness factor within the feature. In some embodiments tungsten is preselected by heating substantially pure tungsten, pure tungsten, tungsten alloy, or tungsten material to above 400 degrees Celsius such as at least 450 degrees Celsius; and forming the tungsten layer atop a dielectric layer such as substrate 200, wherein the dielectric layer is disposed within or forms the feature. In embodiments, the tungsten layer is formed of pretreated tungsten, wherein the pretreated tungsten has an increased hardness value and increase grain size compared to non-pretreated tungsten. Suitable process conditions for depositing tungsten layer 225 include process conditions, such as temperature suitable to heat the substrate at a temperature in the range from about 450 degrees C to about 600 degrees C., or in the range from about 450 degrees C to about 500 degrees C. In embodiments, the process chamber for depositing tungsten is maintained at a pressure in the range from about 1 Torr to about 150 Torr, or in the range from about 5 Torr to about 90 Torr.

In some embodiments, tungsten is deposited into the feature by chemical vapor deposition (CVD). Non-limiting examples of CVD processes suitable for deposition of the tungsten layer 225 are disclosed in commonly-owned U.S. Patent No. 7,405,158, issued July 29, 2008 to Lai et al.

In some embodiments, the thickness of the tungsten layer 225 is predetermined to fill a gap in a feature such as a trench, via, self aligned via, duel damascene structure, or the like. In embodiments, the shape of the tungsten layer 225 is substantially uniform and fills the feature at least to the top surface 240 of the substrate 200. In embodiments, tungsten layer 225 completely fills the feature to overfill trench 210. As shown in Figure 2B, a first portion 228 of the tungsten layer 225 is shown as overburden extending above the top surface 240 of the substrate 200 and atop the top surface 240 of the substrate 200. In some embodiments, tungsten layer 225 is deposited within a feature such as a via or trench 210 and atop substrate 200 such that overburden is deposited on the field region or top surface 240 of substrate 200. In embodiments, a first top surface 242 of the tungsten layer 225 is at a level above the top of the feature such as trench 210 or top surface 240 of the substrate 200. As shown in Figure 2B, a first portion 228 of the tungsten layer 225 may include the first top surface 242 of the tungsten layer 225 having a rough or non-flat surface. A second portion 229 of the tungsten layer 225 fills the feature such as trench 210 from the bottom surface of first portion 228 of the tungsten layer 225 to the bottom surface 222 of the feature such as trench 210.

Referring to Figure 1 at 104, embodiments of the present disclosure include leveling a first top surface of a tungsten layer within a feature and atop a top surface of a substrate. For example, in some embodiments, first top surface 242 of tungsten layer 225 as shown in Figure 2B is leveled to form first level top surface 248 of the tungsten layer 225 as shown in Figure 2C. First level top surface 248 of the tungsten layer 225 is flat or substantially flat, such that is sits upon an imaginary horizontal line above the feature such as a via or trench 210. Leveling the first top surface 242 of the tungsten layer at 225 within the feature and atop the top surface of substrate 200 may be performed by chemical mechanical planarization (CMP) techniques and the like. In embodiments, first level top surface 248 of the tungsten layer 225 is flat or substantially flat, and also has a smooth surface.

In embodiments, planarizing the first top surface 242 of the tungsten layer 225 having a portion (such as second portion 229) disposed within a feature such as trench 210 and a portion (such as first portion 228 of the tungsten layer 225 described above) protruding from the feature, may form, as shown in figure 2C, a first level top surface 248 of the tungsten layer 225 on the protruding portion such as the first portion 228 of the tungsten layer 225 described above. In some embodiments, the first level top surface 248 of the tungsten layer 225 is disposed upon a dielectric layer as described above. In embodiments, leveling of first top surface 242 includes planarizing the first portion of the tungsten layer atop the substrate to form a first level top surface 248 of the tungsten layer 225 above the top surface 240 of the substrate 200.

Referring to Figure 2C, the first level top surface 248 of the tungsten layer 225 is formed as a level or substantially level surface free of rough or jagged deformities. In embodiments, the first level top surface 248 of the tungsten layer 225 is characterized as flat, or free of rough or dished shapes. Further, the first level top surface 248 of the tungsten layer 225 is shaped as a flat plane horizontal to a base plane. In some embodiments, the first level top surface 248 of the tungsten layer 225 is shaped as a straight or flat surface positioned horizontally from, or parallel to, base 214 and/or bottom surface 222.

In embodiments, etching in accordance with the present disclosure is performed on the first level top surface 248 which may be a substantially level top surface of the tungsten layer 225. Referring to Figure 1 at 106 and Figure 2D, tungsten etch in accordance with the present disclosure removes tungsten from atop substrate 200 or dielectric layer and the first level top surface 248 of the tungsten layer 225, to form a level below the top surface 240 of the substrate 200. In some embodiments etching the first level top surface of the tungsten layer includes contacting the first level top surface 248 with an oxide, peroxide such as hydrogen peroxide, and/or one of a strong acid or a strong base to remove the first portion 228 of the tungsten layer 225 from atop the substrate 200 to form a second top surface 260 of the tungsten layer 225 at a level below the top surface 240 of the substrate 200 and within the feature. In some embodiments, etching the first level top surface 248 of the tungsten layer 225 includes contacting the first level top surface 248 with a hydrogen peroxide and one of a strong acid or a strong base to remove the first portion 228 of the tungsten layer 225 from atop the substrate 200 to form a second top surface 260 of the tungsten layer 225 at a level below the top surface 240 of the substrate 200. In some embodiments etching the first level top surface of the tungsten layer includes contacting the first level top surface 248 with an oxide, peroxide such as hydrogen peroxide to remove the first portion 228 of the tungsten layer 225 from atop the substrate 200 to form a second top surface 260 of the tungsten layer 225 at a level below the top surface 240 of the substrate 200 and within the feature. In some embodiments, etching the first level top surface 248 of the tungsten layer 225 includes contacting the first level top surface 248 with a hydrogen peroxide to remove the first portion 228 of the tungsten layer 225 from atop the substrate 200 to form a second top surface 260 of the tungsten layer 225 at a level below the top surface 240 of the substrate 200. In embodiments, etching is for a time sufficient to etch the tungsten layer to form a substantially level, or substantially flat, second top surface 260 of the tungsten layer 225 within the feature. In embodiments, the second top surface 260 is free of rough or jagged deformities. In embodiments, the second top surface 260 is characterized as flat, or free of rough or dished shapes. Further, the second top surface 260 is shaped as a flat plane horizontal to, or parallel to, a base plane (such as the general plane of the substrate). In some embodiments, the second top surface 260 is a straight or flat surface positioned horizontally from, or parallel to, base 214 and/or bottom surface 222 within the feature.

In some embodiments, the depth of the formation of second top surface 260 of the tungsten layer 225 may be controlled by, e.g. adjusting the etch duration. In some embodiments, the landing or depth of the second top surface 260 may be controlled or lowered within the feature such as trench 210 by extending the amount of time the etch solution (e.g., combination of peroxide and acid or base) is in contact with tungsten layer 225. In embodiments, the landing or depth of the second top surface 260 may be lowered within the feature such as trench 210 be lengthening the amount of time the etch solution (e.g., hydrogen peroxide and HCI) is in contact with tungsten layer 225. Non-limiting examples of suitable times sufficient to etch the tungsten layer to form, for example, a substantially level second top surface 260 within the feature include 1 second to 5 minutes, 1 second to 1 minute, 30 seconds to 1 minute, 10 seconds to 50 seconds, 20 seconds to 40 seconds, 30 seconds to 35 seconds, or about 30 to 40 seconds.

In embodiments, etching is characterized as an *in situ* wet etch, where the oxide constituent, and acid constituent or base constituent of the wet etch solution are added together to contact the first level top surface 248 of the tungsten layer 225 together. In embodiments, the etch is characterized as an *in situ* wet etch, for example where an oxide constituent such as hydrogen peroxide, and acid constituent are added simultaneously. In embodiments, the etching is characterized as highly selective towards the tungsten layer over the dielectric layer. In some embodiments, oxidant such as peroxide (e.g., hydrogen peroxide) is added in amounts sufficient to oxidize the top layer of tungsten upon or within the feature such as when the oxidant contacts the tungsten.

In some embodiments, acid such as HCL is added in amounts sufficient to etch oxidized tungsten. Non-limiting examples of acid includes dilute acid, concentrated acid, or acids solutions containing about 1% to about 90% acid. In embodiments, a strong acid such as an acid that completely ionizes in water to give one or more protons per acid molecule may be suitable for use in accordance with the present disclosure. In embodiments, suitable strong acids for use in accordance with the present disclosure include acid having a pH of 3 or lower. One non-limiting example of a suitable acid for use in accordance with the present disclosure is hydrochloric acid (HCI). In embodiments, mild to strong acids are suitable for use in accordance with the present disclosure. In embodiments, organic and inorganic acids are suitable for use in accordance with the present disclosure.

In some embodiments, base is added in amounts sufficient to etch oxidized tungsten. In embodiments, a strong base such as a base that completely ionizes in water to give hydroxide ions (OH-) may be suitable for use in accordance with the present disclosure. In embodiments, suitable strong bases for use in accordance with the present disclosure include base having a pH of 12 or higher. In embodiments, a base such as NH₄OH may be added in amounts sufficient to etch oxidized tungsten. Non-limiting examples of base includes dilute base, concentrated base, or basic solutions containing about 1% to about 90% base. In embodiments, a strong base is NH₄OH. In some embodiments, base suitable for use in accordance with the present disclosure includes KOH, NaOH, NH₄OH, CsOH, or any alkaline hydroxide. In embodiments, one or more weak water soluble bases may be suitable for use herein.

In some embodiments, hydrogen peroxide is suitable for use as an etching solution. For example, a method of etching tungsten, includes: leveling a first top surface of a tungsten layer within a feature and atop a top surface of a substrate; and etching the tungsten layer with a hydrogen peroxide etching solution to remove a first portion of the tungsten layer from atop the substrate to form a second top surface of a tungsten layer at a level below the top surface of the substrate. Further, some embodiments, include a method of etching tungsten, including: planarizing a top surface of a tungsten layer having a first portion disposed within a feature and a second portion protruding from the feature to form a first level top surface on the second portion, wherein the first portion is disposed upon a dielectric layer; and contacting the first level top surface with an etch solution including, or consisting of hydrogen peroxide for a time sufficient to etch the second portion to form a second level top surface on the first portion within the feature. In embodiments, the hydrogen peroxide etching solution is an aqueous solution of hydrogen peroxide, including concentrations of at least 35%, at least 50%, or at least 70%.

In some embodiments, methods of etching tungsten are disclosed including: leveling a first top surface of a tungsten layer within a feature and atop a top surface of a substrate; and etching the tungsten layer with a peroxide such as hydrogen peroxide and one of a strong acid or a strong base to remove a first portion of the tungsten layer from atop the substrate to form a second top surface of a tungsten layer at a level below the top surface of the substrate. The methods are suitable for forming substantially level or flat top surfaces of a tungsten layer at a level below the top surface of the substrate or within one or more features such as vias or trenches

In some embodiments, water is suitable for use as an etching solution.

In embodiments, the etch rate of the tungsten layer is 1 nm/min to 50 nm/min, 1nm/min to 10 nm/min, 1nm/min to 5 nm/min.

In embodiments, the etch reaction is performed under ambient temperature and pressure conditions. In some embodiments, the etch reaction is performed at a pressure of 1 Torr to 800 Torr, and/or at a temperature of 10 degrees Celsius to 100 degrees Celsius.

In embodiments, etching may be terminated by removing the etch solution, washing the one or more features, and drying the feature filled substrate. For example, washing may be performed by contacting the feature filled substrate with water. Drying may be performed under gas such as argon, or nitrogen.

While the foregoing is directed to embodiments of the present disclosure, other and further embodiments of the disclosure may be devised without departing from the basic scope thereof.

## Claims

1. A method of etching tungsten, comprising:
leveling a first top surface of a tungsten layer within a feature and atop a top surface of a substrate; and
etching the tungsten layer with a hydrogen peroxide and one of a strong acid or a strong base to remove a first portion of the tungsten layer from atop the substrate to form a second top surface of a tungsten layer at a level below the top surface of the substrate.

2. The method of claim 1, wherein leveling comprises planarizing the first portion of the tungsten layer atop the substrate to form a first substantially level top surface of a tungsten layer above the top surface of the substrate.

3. The method of claims 1 or 2, wherein the tungsten layer comprises substantially pure tungsten, pure tungsten, tungsten alloys, and combinations thereof.

4. The method of any of claims 1 - 3, wherein the tungsten layer is formed of pretreated tungsten, wherein the pretreated tungsten has an increased hardness value and increase grain size compared to non-pretreated tungsten.

5. The method of any of claims 1 - 4, further comprising heating substantially pure tungsten, pure tungsten, tungsten alloy, or tungsten material to at least 450 degrees Celsius; and forming the tungsten layer atop a dielectric layer, wherein the tungsten layer is disposed within the feature.

6. The method of any of claims 1 - 5, wherein the etching is characterized as highly selective towards the tungsten layer over the substrate.

7. The method of any of claims 1 - 6, wherein the strong acid is HCI, or the strong base is NH₄OH.

8. The method of any of claims 1 -7, wherein the etching is for a time sufficient to etch the tungsten layer to form a substantially level second top surface within the feature.

9. The method of claim 8, wherein the time is 1 second to 5 minutes.

10. The method of any of claims 1 - 9, wherein the feature is a high aspect ratio trench having a width of less than 20 nanometers.

11. The method of claim 10, wherein the high aspect ratio trench comprises an opening, a surface opposite the opening, and two sidewalls between the opening and surface opposite the opening.

12. The method of any of claims 1 -11, wherein the tungsten layer is disposed upon a top surface of a dielectric layer, and wherein the dielectric layer is within the feature.

13. The method of claim 12, wherein the dielectric layer comprises silicon nitride, silicon monoxide, or combinations thereof.

14. A method of etching tungsten, comprising:
planarizing a top surface of a tungsten layer disposed atop a substrate and above a feature formed in a dielectric layer of the substrate to form a first level top surface of the tungsten layer above the feature; and
contacting the first level top surface of the tungsten layer with an etch solution comprising an oxidizing agent and one of a strong acid or strong base for a time sufficient to etch the first level top surface of the tungsten layer to form a second level top surface of the tungsten layer within the feature.

15. A method of etching a tungsten layer disposed on a substrate, comprising:
contacting a substantially level first top surface of a tungsten layer with hydrogen peroxide, and optionally one of a strong acid or a strong base for a time sufficient to etch the substantially level first top surface of the tungsten layer to form a substantially level second top surface within a feature disposed in the substrate.
